# EUROPEAN PATENT APPLICATION

(11) **EP 2 664 427 A1**
(43) Date of publication of application: **20.11.2013**
(21) Application number: 11855493.0
(22) Date of filing: 20.07.2011
(51) Int. Cl.: B29C 33/02, B29C 59/02, H01L 21/027

(54) **TEMPERATURE ADJUSTING DEVICE, AND IMPRINTING DEVICE USING SAME**

(30) Priority: 10.01.2011 JP 2011002613
(71) Applicant: Scivax Corporation, Kawasaki-shi, Kanagawa 213-0012 (JP)
(72) Inventor: KAWAGUCHI, Hirosuke, Kawasaki-shi Kanagawa 213-0012 (JP); TANAKA, Satoru, Kawasaki-shi Kanagawa 213-0012 (JP)
(74) Representative: Gille Hrabal
(86) International application number: PCT/JP2011/066500
(87) International publication number: WO 2012/096019

(57) **Abstract**

A temperature adjusting device that can heat and cool an object like a mold or a molding target uniformly and quickly, and an imprinting device using the same are provided. The temperature adjusting device is for adjusting a temperature of the object like a mold 100 or a molding target 200, and includes fluid supplying means 1 for supplying a fluid at a predetermined temperature from a plurality of supply openings 11, holding means 2 including a holding face 21 that holds the object, and a fluid receiving face 22 that receives the fluid supplied from the supply openings 11, a temperature adjusting housing 3 that constructs, together with the holding means 2, a temperature adjusting chamber 31 which retains thereinside the supply openings 11, and a discharging channel 4 that discharges the fluid in the temperature adjusting chamber 31.

## Description

### Technical Field

The present invention relates to a temperature adjusting device for adjusting a temperature of an object uniformly and quickly, and an imprinting device using the same.

### Background Art

In recent years, a nanoimprinting technology is getting attention which depresses a mold against a molding target like a resin, thereby transferring a minute molding pattern in a micrometer or nanometer order. A thermal imprinting method and a photo imprinting method are known as the nanoimprinting technology.

In the case of the thermal imprinting method, a thermoplastic resin is used as a molding target, such a thermoplastic resin is heated to a temperature equal to or higher than a glass transition temperature, a mold is depressed at predetermined pressure, and the molding target is cooled to a temperature lower than the glass transition temperature to transfer a molding pattern of the mold on the thermoplastic resin. In this case, the heating is performed by a heater, etc., while the cooling is performed by letting a cooling water to flow through a cooling channel (see, for example, Patent Literature 1).

In the case of the photo imprinting method, a photo-curable resin is used as a molding target, a mold is depressed against the photo-curable resin at predetermined pressure, and the photo-curable resin is irradiated with light in this condition to transfer a molding pattern of the mold on the photo-curable resin. In this case, also, since a curing speed of the photo-curable resin and a cure shrinkage thereof differ depending on a temperature at the time of curing, a curing operation at a uniform temperature is necessary, and it is essential to perform a temperature adjustment especially in the case of a large area.

Patent Literature 1: International Publication No. WO 2004/062886

### Disclosure of Invention

### Problem to be Solved by the Invention

According to the conventional methods, however, a temperature difference occurs between a portion where a heater or a cooling channel passes through and a portion where no heater or cooling channel passes through. Moreover, the cooling channel has a temperature difference that occurs between the upstream side of the channel and the downstream side thereof. When a temperature difference occurs as explained above in a molding face, there is a disadvantage that a transfer unevenness of a pattern occurs depending on a difference in a thermal expansion with a resin, etc. Furthermore, since the heater and the cooling channel cannot be provided in the same portion at the same time, there is also a disadvantage that either one of the heater and the cooling channel is distant from the mold and the molding target, and a temperature adjustment and a quick temperature rise/drop are difficult.

Hence, it is an object of the present invention to provide a temperature adjusting device that can heat and cool an object like a mold or a molding target uniformly and quickly, and an imprinting device using the same.

### Means for Solving the Problem

In order to accomplish the above object, a temperature adjusting device of the present invention is for adjusting a temperature of an object, and includes: fluid supplying means for supplying a fluid at a predetermined temperature from a plurality of supply openings; holding means, the holding means comprising: a holding face that holds the object; and a fluid receiving face that receives the fluid supplied from the supply openings; a temperature adjusting housing that constructs, together with the holding means, a temperature adjusting chamber which retains thereinside the supply openings; and a discharging channel that discharges the fluid in the temperature adjusting chamber.

In this case, it is preferable that the fluid receiving face should include a plurality of concavities or convexities arranged in accordance with respective positions of the supply openings in order to increase a heat-transfer area.

When the object needs heating, the fluid supplying means may be include: a first heating tank and a second heating tank that heat the fluid to a predetermined temperature; a supply channel that selectively connects the first heating tank or the second heating tank with the supply openings; and the discharging channel that selectively connects the temperature adjusting chamber with the first heating tank or the second heating tank, or may include: a heating tank that heats the fluid to a predetermined temperature; a supply channel that connects the heating tank with the supply openings; supply channel opening/closing means for opening and closing the supply channel; a collecting tank connected to the discharging channel; a circulation flow channel that connects the collecting tank with the heating tank; and circulation flow channel opening/closing means for opening and closing the circulation flow channel.

When the object needs cooling, the fluid supplying means may include: a cooling tank that reserves a cooling fluid; a cooling fluid supply channel that connects the cooling tank with the supply openings; and a pump for letting the fluid in the cooling tank to flow from the supply openings.

An imprinting device of the present invention is for transferring a molding pattern of a mold on a molding target, and includes: fluid supplying means for supplying a fluid at a predetermined temperature from a plurality of supply openings; holding means, the holding means comprising: a holding face that holds the mold or the molding target; and a fluid receiving face that receives the fluid supplied from the supply openings; a temperature adjusting housing that constructs, together with the holding means, a temperature adjusting chamber which retains thereinside the supply openings; and a discharging channel that discharges the fluid in the temperature adjusting chamber.

### Effect of the Invention

The temperature adjusting device of the present invention can uniformly heat or cool the whole surface of an object. Moreover, heating and cooling can be performed through the same mechanism. Since a heat-transfer area can be increased and a heat transfer fluid is sprayed to increase a film heat-transfer coefficient, fast temperature raise and cooling are enabled. Furthermore, since a fluid at a predetermined temperature is used, an overshoot can be reduced even if a fast temperature rise/drop is carried out.

### Brief Description of Drawings

FIG 1 is a cross-sectional view illustrating a temperature adjusting device according to the present invention;
FIG. 2 is a cross-sectional view illustrating a temperature adjusting device according to the present invention;
FIG 3 is a cross-sectional view illustrating a temperature adjusting device according to the present invention; and
FIG. 4 is a cross-sectional view illustrating a temperature adjusting device according to the present invention;

### Description of Reference Numerals

- 1: Fluid supplying means
- 2: Holding means
- 3: Temperature adjusting housing
- 4: Discharging channel
- 11: Supply opening
- 12: Heating tank
- 13: Supply channel
- 14: Supply channel opening/closing means
- 15: Collecting tank
- 16: Circulation flow channel
- 17: Circulation flow channel opening/closing means
- 19: Pump
- 21: Holding face
- 22a: Concavity
- 22b: Convexity
- 22: Fluid receiving face
- 31: Temperature adjusting chamber
- 41: Discharging channel
- 100: Mold
- 121: First heating tank
- 122: Second heating tank
- 123: Cooling tank
- 124: Cooling fluid supply channel
- 131: Supply channel
- 200: Molding target

### Best Mode for Carrying Out the Invention

A temperature adjusting device of the present invention is for adjusting a temperature of an object, and mainly includes fluid supplying means 1 which supplies a fluid at a predetermined temperature from a plurality of supply openings 11 evenly disposed at a predetermined pitch, holding means 2 that has a holding face 21 holding an object and a fluid receiving face 22 receiving the fluid supplied from the supply openings 11, a temperature adjusting housing 3 which constructs, together with the holding means 2, a temperature adjusting chamber 31 that retains thereinside the supply openings 11, and a discharging channel 4 that discharges the fluid in the temperature adjusting chamber 31.

The object means an object subjected to a temperature adjustment by the temperature adjusting device of the present invention, and corresponds to, in the case of the imprinting molding, a mold 100 having a predetermined molding pattern or a molding target 200.

The mold 100 is formed of, for example, a "metal like nickel", "ceramics", a "carbon material like glass-like carbon", or "silicon", and has a predetermined pattern at an end face (a molding-target face). This pattern can be formed by performing precise machining on the molding-target face of the mold. Moreover, the molding pattern can be formed by a semiconductor microfabrication technology like etching on a silicon substrate, or by forming a metal plating on the surface of the silicon substrate, etc., through an electrical casting (electroforming) technique, e.g., nickel plating, and by peeling off the metal plating layer. Furthermore, it is possible to use a resin-made mold prepared by an imprint technology. In this case, the mold may be formed as a film having flexibility with respect to the molding-target face of the molding target 200. Needless to say, the material and production method of the mold 100 are not limited to any particular ones as long as a minute pattern can be formed.

A molding pattern formed on the mold 100 includes not only a pattern in a geometrical shape formed of a concavo-convex structure, but also, for example, a pattern for transferring a predetermined surface condition like a transfer of a mirror condition with a predetermined surface roughness, and a pattern for transferring an optical element like a lens with a predetermined curved face. The molding pattern is formed in such a way that the minimum dimension of a width of the convexity and that of the concavity in a planar direction is formed in various sizes, such as equal to or smaller than 100 µm, equal to or smaller than 10 µm, equal to or smaller than 2 µm, equal to or smaller than 1 µm, equal to or smaller than 100 nm, and equal to or smaller than 10 nm. Moreover, a dimension in the depth direction is also formed in various sizes, such as equal to or larger than 10 nm, equal to or larger than 100 nm, equal to or larger than 200 nm, equal to or larger than 500 nm, equal to or larger than 1 µm, equal to or larger than 10 µm, and equal to or larger than 100 µm.

The molding target 200 is for example, a thermoplastic resin or a resin that is produced through a polymerization reaction (thermal curing or photo curing) of polymerization-reactive-group containing compounds.

Examples of a thermoplastic resin available are a cyclic-olefin-based resin, such as a cyclic olefin ring-opening polymer/hydrogenation (COP) or a cyclic olefin copolymer (COC), an acrylic resin, polycarbonate, a vinyl-ether resin, a fluororesin, such as perfluoro-alkoxy-alkane (PFA) or poly-tetra-fluoro-ethylene (PTFE), polystyrene, a polyimide resin, and a polyester resin.

Example resins produced through a polymerization reaction (thermal curing or photo curing) of polymerization-reactive-group containing compounds are compounds containing unsaturated hydrocarbon group like vinyl group or allyl group, such as epoxide-containing compounds, (metha) acrylic-ester compounds, vinyl-ether compounds, and bisallylnadiimide compounds. In this case, a polymerization-reactive-group containing compound can be used solely in order to let it thermally polymerized, or can be used in combination with a thermal-reactive initiator in order to improve a thermal curing property. Moreover, a polymerization-reactive-group containing compound which can form a molding pattern by proceeding a polymerization reaction through irradiation with light when a photoreactive initiator is added can be used. Example heat-reactive radical initiators suitably available are organic peroxide and azo compound, and example photoreactive radical initiators suitably available are an acetophenone derivative, a benzophenone derivative, a benzoin ether derivative, and a xanthone derivative. Moreover, a reactive monomer can be used without a solvent, or can be used in a condition dissolved in a solvent and desolvated after it is applied.

As the molding target 200, ones formed as a flexible film or formed as a layer on a substrate formed of an inorganic compound like silicon or a metal can be used.

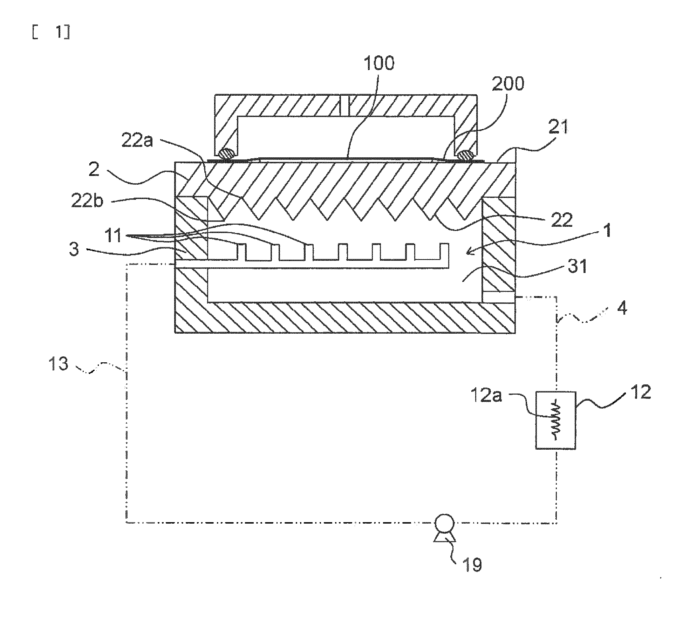

In FIGS. 1 to 3, the mold 100 is disposed at the holding-means-2 side, but the molding target 200 may be disposed at the holding-means-2 side.

The explanation below will be given of a case in which the temperature adjusting device of the present invention is applied to an imprinting device, but can be applied to other devices.

An example fluid is a liquid having a higher boiling point than a heating temperature of an object and having a lower melting point than a cooling temperature of the object. For example, a liquid, such as water or oil, can be used. A gas like a saturated water vapor can be also used.

The holding face 21 of the holding means 2 is for holding an object like the mold 100 or the molding target 200, and is formed in a predetermined shape in accordance with the shape of the object. When, for example, an object is a flat substrate or mold in the case of the imprinting molding, in order to enable uniform pressurization, one having a flatness as high as possible is used. Moreover, in order to fasten the object, such as the mold 100 or the molding target 200, fastening means (unillustrated) like a vacuum chuck may be provided.

The material of the holding means 2 is not limited to any particular one as long as it has a good thermal conductivity, and has a heat resistance and a pressure resistance with respect to a molding condition in an imprinting process, and for example, a steel material like carbon steel or a metal like SUS can be used.

The fluid receiving face 22 of the holding means 2 is not limited to any particular shape as long as it can receive a fluid supplied from the supply openings 11, but in order to enable an efficient heat exchange with the fluids, it is preferable that the fluid receiving surface should have a plurality of concavities 22a or convexities 22b which increase a surface area. Moreover, in order to let a temperature of the holding-face-21 side to be uniform, the concavities 22a or the convexities 22b may be evenly arranged in accordance with the positions of the supply openings 11. The concavities 22a or the convexities 22b may be in any shapes, but those can be formed in, for example, a square pyramid which can be disposed evenly. As an example, ones each having a height of 2.5 mm and an angle of 45 degrees and arranged evenly at a pitch of 5 mm can be used.

The temperature adjusting housing 3 is disposed at the fluid-receiving-face side of the holding means 2, and constructs, together with the holding means 2, the temperature adjusting chamber 31 that retains thereinside the supply openings 11. Moreover, the discharging channel 4 for discharging the fluid supplied to the fluid receiving face 22 of the holding means 2 is connected to the bottom of the temperature adjusting housing 3. The temperature adjusting housing 3 is not limited to any particular one as long as it has a pressure resistance good enough to withstand an internal pressure at the time of temperature adjustment, but it is preferable that the temperature adjusting housing should have a heat insulation property as high as possible. Moreover, the holding means 2 and a temperature adjusting housing may be formed together.

The discharging channel 4 may be constructed so as to discharge the fluid in the temperature adjusting chamber 31, or may be constructed so as to reuse the fluid by returning it to the fluid supplying means 1.

The fluid supplying means 1 is not limited to any particular one as long as it can supply a fluid at a predetermined temperature, but, for example, as illustrated in FIG. 1, when the object like the mold 100 or the molding target 200 is heated, the fluid supplying means including a heating tank 12 which heats the fluid to a predetermined temperature, a supply channel 13 which connects the heating tank 12 with the supply openings 11, and a pump 19 for letting the fluid in the heating tank 12 to flow from the supply openings 11 may be used.

The supply openings 11 are arranged appropriately at respective positions where the object held by the holding means 2 can be heated uniformly. Moreover, the supply openings 11 are constructed to supply or to spray the fluid to the fluid receiving face 22 at the right angle.

The heating tank 12 includes heating means 12a like an electric heater for heating the fluid, and temperature detecting means (unillustrated) like a thermocouple for detecting the temperature of the fluid, thereby heating the fluid to a predetermined temperature.

This fluid supplying means 1 heats the fluid in the heating tank 12 to a predetermined temperature in advance, and when heating the object (mold 100 and molding target 200), actuates the pump 19 and supplies the fluid from the supply openings 11 to the fluid receiving face 22 of the holding means 2. This causes the holding means 2 to be heated, and the object held by the holding means 2 can be heated uniformly. The fluid supplied to the fluid receiving face 22 is discharged from the temperature adjusting chamber 31 through the discharging channel 4.

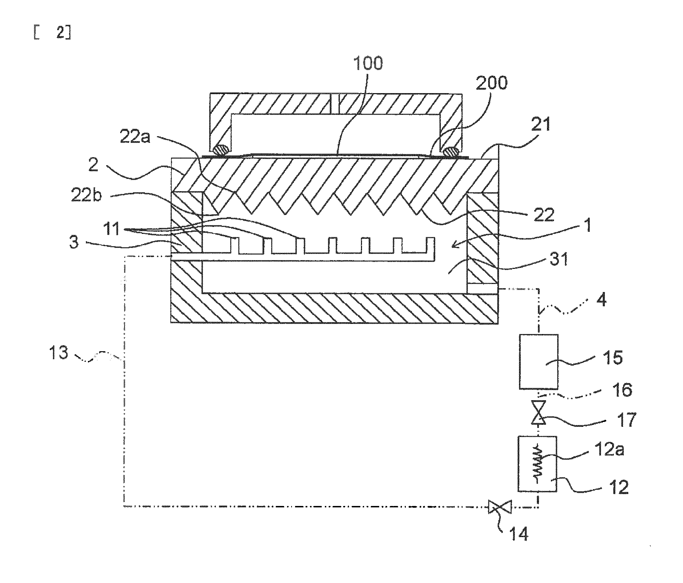

When a liquid is used as the fluid, a liquid which is heated under a pressure equal to or higher than the atmospheric pressure to a temperature higher than a boiling point at the atmospheric pressure can be used. In this case, as illustrated in FIG. 2, for example, the fluid supplying means 1 includes the heating tank 12 which heats the fluid to a predetermined temperature, the supply channel 13 which connects the heating tank 12 with the supply openings 11, supply channel opening/closing means 14 for opening and closing the supply channel 13, a collecting tank 15 connected to the discharging channel 4, a circulation flow channel 16 which connects the collecting tank 15 with the heating tank 12, and circulation flow channel opening/closing means 17 for opening and closing the circulation flow channel 16.

The heating tank 12 includes the heating means 12a like an electric heater for heating the fluid, and the temperature detecting means (unillustrated) like a thermocouple for detecting the temperature of the fluid, thereby heating the fluid to a predetermined temperature. Moreover, pressure detecting means (unillustrated) for detecting an internal pressure of the heating tank 12 may be disposed. Note that the heating tank 12 needs a pressure resistance equal to or higher than a vapor pressure of the heated fluid. Moreover, the supply channel 13 is connected to the bottom of the heating tank 12.

In order to let the fluid to be flown by the gravity, it is preferable that the collecting tank 15 should be disposed downwardly of the temperature adjusting chamber 31 and upwardly of the heating tank 12. This enables the fluid supplying means 1 to circulate the fluid without a pump. Moreover, as a preparation for the next heating, pre-heating means (unillustrated) like an electric heater may be provided which heats the fluid in the collecting tank 15 in advance.

This fluid supplying means 1 lets the supply channel opening/closing means 14 and the circulation flow channel opening/closing means 17 to be closed, and heats the liquid (fluid) in the heating tank 12 to a predetermined temperature having a higher vapor pressure than an internal pressure of the temperature adjusting chamber 31. Next, when the supply channel opening/closing means 14 is opened, since the vapor pressure in the heating tank 12 is higher than the internal pressure of the temperature adjusting chamber 31, the liquid in the heating tank 12 is supplied to the fluid receiving face 22 of the holding means 2 through the supply openings 11. This causes the holding means 2 to be heated, and the object (mold 100 and molding target 200) held by the holding means 2 can be heated uniformly. The liquid supplied to the fluid receiving face 22 is discharged from the temperature adjusting chamber 31 to the collecting tank 15 through the discharging channel 4. When heating of the object completes, the supply channel opening/closing means 14 is closed and the circulation flow channel opening/closing means 17 is opened, and thus the liquid in the collecting tank 15 is returned to the heating tank 12, and is reused for the next heating.

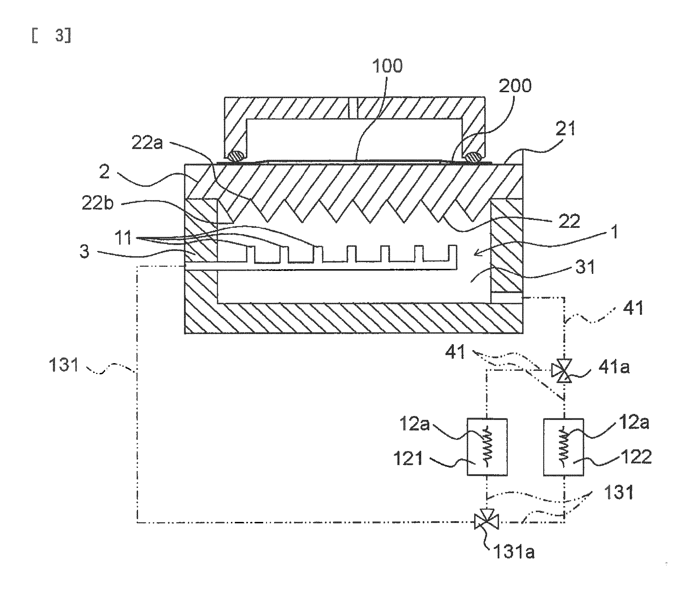

As illustrated in FIG. 3, the fluid supplying means 1 may be constructed so as to include a first heating tank 121 and a second heating tank 122 that heat the fluid to a predetermined temperature, a supply channel 131 that selectively connects the first heating tank 121 or the second heating tank 122 with the supply openings 11, and a discharging channel 41 that selectively connects the temperature adjusting chamber 31 with the first heating tank 121 or the second heating tank 122.

The supply channel 131 is provided with supply channel changing means 131a, e.g., a three-way valve which selectively changes the first heating tank 121 or the second heating tank 122 with the supply openings 11.

The first heating tank 121 and the second heating tank 122 each include the heating means 12a like an electric heater for heating the fluid, and the temperature detecting means (unillustrated) like a thermocouple for detecting the temperature of the fluid, thereby heating the fluid to a predetermined temperature. Moreover, the pressure detecting means (unillustrated) for detecting an internal pressure of the heating tank 12 may be disposed. Note that the first heating tank 121 and the second heating tank 122 need to have a pressure resistance equal to or higher than a vapor pressure of the heated fluid. Furthermore, the supply channels 131 are connected to the bottoms of the first heating tank 121 and the second heating tank 122, respectively.

In order to let the fluid to be flown by the gravity, it is preferable that the first heating tank 121 and the second heating tank 122 should be disposed downwardly of the temperature adjusting chamber 31. This enables the fluid supplying means 1 to circulate the fluid without a pump.

The discharging channel 41 is provided with discharging channel changing means 41a, e.g., a three-way valve which selectively connects the temperature adjusting 31 with the first heating tank 121 or the second heating tank 122.

This fluid supplying means 1 causes the first heating tank 121 to be changed to a closed condition by the supply channel changing means 131a and the discharging channel changing means 41a, and heats the liquid (fluid) in the first heating tank 121 to a predetermined temperature having a higher vapor pressure than an internal pressure of the temperature adjusting chamber 31. Next, when the supply channel changing means 131a is changed to the side where the first heating tank 121 is in communication with the supply openings 11, since the vapor pressure in the first heating tank 121 is higher than the internal pressure of the temperature adjusting chamber 31, the liquid in the first heating tank 121 is supplied to the fluid receiving face 22 of the holding means 2 through the supply openings 11. This causes the holding means 2 to be heated, and the object (mold 100 and molding target 200) held by the holding means 2 can be heated uniformly. At this time, the liquid supplied to the fluid receiving face 22 is discharged from the temperature adjusting chamber 31 to the second heating tank 122 through the discharging channel 41. In the second heating tank122, the liquid is heated beforehand within a range where a vapor pressure does not become higher than the internal pressure of the temperature adjusting chamber 31. When heating of the object completes, the fluid supplying means changes the second heating tank 122 to be in a closed condition by the discharging channel changing means 41 a. After the liquid in the second heating tank 122 is heated to a predetermined temperature having a higher vapor pressure than the internal pressure of the temperature adjusting chamber 31, the supply channel changing means 131a is changed to the side where the second heating tank 122 is in communication with the supply openings 11. This causes the liquid in the second heating tank 122 to be supplied to the fluid receiving face 22 of the holding means 2 through the supply openings 11 since the vapor pressure in the second heating tank 122 is higher than the internal pressure of the temperature adjusting chamber 31. At this time, the liquid supplied to the fluid receiving face 22 is discharged from the temperature adjusting chamber 31 to the first heating tank 121 through the discharging channel 41.

By employing the above-explained structures, the object can be heated quickly, and the throughput can be improved.

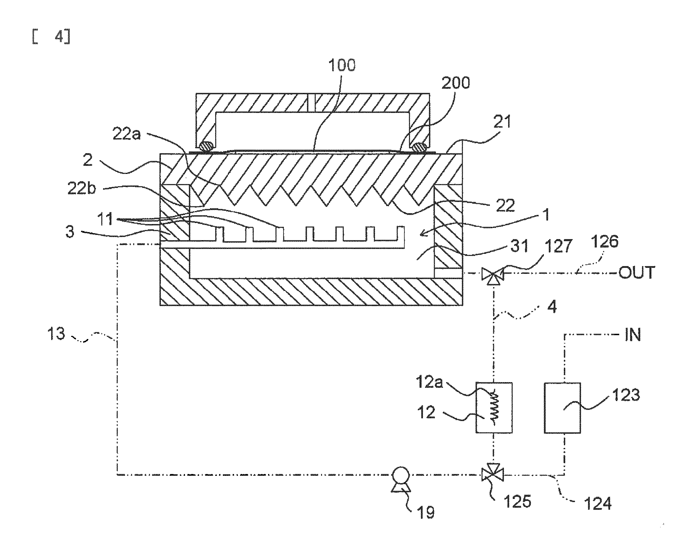

When the object (mold 100 and molding target 200) is cooled, as illustrated in FIG 4, the fluid supplying means may be configured by a cooling tank 123 which reserves a cooling fluid, a cooling fluid supply channel 124 which connects the cooling tank 123 with the supply openings 11, and the pump 19 for flowing the fluid in the cooling tank 123 through the supply openings 11.

The cooling fluid is not limited to any particular one as long as it can be a lower temperature than that of the object, but for example, water can be used.

Hence, the mold 100 or the molding target 200 heated in imprint molding can be cooled uniformly.

When heating and cooling are performed through the common supply openings 11, as illustrated in FIG. 4, the cooling fluid supply channel 124 may be connected to the supply channel 13 through changing means 125 like a three-way valve. Moreover, a discarding channel 126 for discarding the cooling fluid may be provided, and connected to the discharging channel 4 through changing means 127 like a three-way valve.

## Claims

1. A temperature adjusting device for adjusting a temperature of an object, the device comprising:
fluid supplying means for supplying a fluid at a predetermined temperature from a plurality of supply openings;
holding means, the holding means comprising:
a holding face that holds the object; and
a fluid receiving face that receives the fluid supplied from the supply openings;
a temperature adjusting housing that constructs, together with the holding means, a temperature adjusting chamber which retains thereinside the supply openings; and
a discharging channel that discharges the fluid in the temperature adjusting chamber.

2. The temperature adjusting device, wherein the fluid receiving face comprises a plurality of concavities or convexities arranged in accordance with respective positions of the supply openings.

3. The temperature adjusting device according to claim 1 or 2, wherein the fluid supplying means comprises:
a first heating tank and a second heating tank that heat the fluid to a predetermined temperature;
a supply channel that selectively connects the first heating tank or the second heating tank with the supply openings; and
the discharging channel that selectively connects the temperature adjusting chamber with the first heating tank or the second heating tank.

4. The temperature adjusting device according to claim 1 or 2, wherein the fluid supplying means comprises:
a heating tank that heats the fluid to a predetermined temperature;
a supply channel that connects the heating tank with the supply openings;
supply channel opening/closing means for opening and closing the supply channel;
a collecting tank connected to the discharging channel;
a circulation flow channel that connects the collecting tank with the heating tank;
and
circulation flow channel opening/closing means for opening and closing the circulation flow channel.

5. The temperature adjusting device according to any one of claims 1 to 4, wherein the fluid supplying means comprises:
a cooling tank that reserves a cooling fluid;
a cooling fluid supply channel that connects the cooling tank with the supply openings; and
a pump for letting the fluid in the cooling tank to flow from the supply openings.

6. The temperature adjusting device according to claim 2, wherein respective shapes of the concavities or the convexities are a square pyramid.

7. An imprinting device for transferring a molding pattern of a mold on a molding target, the imprinting device comprising:
fluid supplying means for supplying a fluid at a predetermined temperature from a plurality of supply openings;
holding means, the holding means comprising:
a holding face that holds the mold or the molding target; and
a fluid receiving face that receives the fluid supplied from the supply openings;
a temperature adjusting housing that constructs, together with the holding means, a temperature adjusting chamber which retains thereinside the supply openings; and
a discharging channel that discharges the fluid in the temperature adjusting chamber.
